# EUROPÄISCHE PATENTANMELDUNG

(11) **EP 3 940 769 A1**
(43) Veröffentlichungstag der Anmeldung: **19.01.2022**
(21) Anmeldenummer: 20186515.1
(22) Anmeldetag: 17.07.2020
(51) Int. Cl.: H01L 23/373

(54) **HALBLEITERMODUL MIT ZUMINDEST EINEM HALBLEITERELEMENT UND EINEM SUBSTRAT**

(71) Anmelder: Siemens Aktiengesellschaft, 80333 München (DE)
(72) Erfinder: Dreher, Patrick, 91074 Herzogenaurach (DE); Wagner, Claus Florian, 90425 Nürnberg (DE); Zeyß, Felix, 93059 Regensburg (DE)

(57) **Zusammenfassung**

Die Erfindung betrifft ein Halbleitermodul (2) mit zumindest einem Halbleiterelement (4) und einem Substrat (6). Um, im Vergleich zum Stand der Technik, eine verbesserte Wärmeabfuhr und höhere Zuverlässigkeit zu erreichen, wird vorgeschlagen, dass das Substrat (6) eine obere Metallisierung (12) aufweist, wobei das zumindest eine Halbleiterelement (4) über eine Verbindungsschicht (30) stoffschlüssig mit der oberen Metallisierung (12) des Substrats (6) verbunden ist, wobei eine Metallisierungsoberfläche (30) der oberen Metallisierung (12) profiliert ausgestaltet ist, wobei die Verbindungsschicht (30) durch die Profilierung (34) der Metallisierungsoberfläche (32) eine variable Stärke (s1, s2) aufweist.

## Beschreibung

Die Erfindung betrifft ein Halbleitermodul mit zumindest einem Halbleiterelement und einem Substrat.

Ferner betrifft die Erfindung einen Stromrichter mit mindestens einem derartigen Halbleitermodul.

Darüber hinaus betrifft die Erfindung ein Verfahren zur Herstellung eines derartigen Halbleitermoduls.

Thermomechanischer Stress in der Lotschicht zwischen einer DCB und einem Leistungshalbleiter, welcher bei zyklischen Belastungen zu einem Versagen führt. Verfließen von Lot bei dem Löten der Leistungshalbleiter auf das DCB Substrat. Minderung thermischer Energieabfuhr durch dicke Lotschichten.

Ein derartiges Halbleiterelement wird üblicherweise für den Betrieb in einem Halbleitermodul auf ein Substrat aufgelötet. Beispielsweise ist das Halbleiterelement als Leistungshalbleiterelement für den Einsatz in einem Stromrichter ausgeführt. Unter einem Stromrichter ist beispielsweise ein Gleichrichter, ein Wechselrichter, ein Umrichter oder ein Gleichspannungswandler zu verstehen. Ein derartiges Halbleiterelement ist beispielsweise als Transistor, als Diode oder als Logikbaustein ausgeführt. Insbesondere ist der Transistor als Insulated-Gate-Bipolar-Transistor (IGBT), Metalloxide-Semiconductor-Field-Effect-Transistor (MOSFET) oder Feldeffekttransistor ausgeführt. Üblicherweise umfasst das Substrat eine im Wesentlichen glatte Metallisierung, auf welche das Halbleiterelement aufgelötet wird. Thermomechanischer Stress in der Lotschicht zwischen dem Halbleiterelement und dem Substrat kann, insbesondere bei zyklischen Belastungen, zu einem Versagen des Halbleiterelements führen. Darüber hinaus führt eine dicke Lotschicht zu einer Minderung der thermischen Energieabfuhr. Darüber hinaus besteht die Gefahr, dass Lot bei einer glatten Metallisierung verfließt, was beispielsweise zu einem Kurzschluss führen kann.

Die Offenlegungsschrift EP 3 625 823 A1 beschreibt ein Leistungsmodul mit mindestens einem Leistungshalbleiter, insbesondere einem Leistungstransistor, welcher eine erste Kontaktfläche und eine der ersten Kontaktfläche gegenüberliegende zweite Kontaktfläche aufweist, und einem Substrat, welches zumindest zwei übereinander angeordnete miteinander verbundene Lagen umfasst. Um eine, im Vergleich zum Stand der Technik, höhere Beständigkeit gegenüber Feuchtigkeit zu erreichen und eine niederinduktive planare Anbindung des mindestens einen Leistungshalbleiters zu ermöglichen, wird vorgeschlagen, dass die erste Lage ein erstes dielektrisches Material mit zumindest einer ersten Metallisierung umfasst, wobei die erste Metallisierung auf einer der zweiten Lage zugewandten Seite angeordnet ist, wobei die zweite Lage ein zweites dielektrisches Material mit zumindest einer zweiten Metallisierung umfasst, wobei die zweite Metallisierung auf einer der ersten Metallisierung abgewandten Seite angeordnet ist, wobei der Leistungshalbleiter über die erste Kontaktfläche mit der ersten Metallisierung verbunden ist, wobei der Leistungshalbleiter in einer ersten Aussparung der zweiten Lage angeordnet ist, wobei eine metallische erste Kapselung derartig angeordnet ist, dass der Leistungshalbleiter fluiddicht gekapselt ist und die zweite Kontaktfläche des Leistungshalbleiters über die erste Kapselung elektrisch leitend mit der zweiten Metallisierung verbunden ist.

Somit besteht die Aufgabe der vorliegenden Erfindung darin, ein Halbleitermodul anzugeben, welches, im Vergleich zum Stand der Technik, eine verbesserte Wärmeabfuhr und höhere Zuverlässigkeit aufweist.

Die Aufgabe wird erfindungsgemäß durch ein Halbleitermodul mit zumindest einem Halbleiterelement und einem Substrat gelöst, wobei das Substrat eine obere Metallisierung aufweist, wobei das zumindest eine Halbleiterelement über eine Verbindungsschicht stoffschlüssig mit der oberen Metallisierung des Substrats verbunden ist, wobei eine Metallisierungsoberfläche der oberen Metallisierung profiliert ausgestaltet ist, wobei die Verbindungsschicht durch die Profilierung der Metallisierungsoberfläche eine variable Stärke aufweist.

Ferner wird die Aufgabe erfindungsgemäß gelöst durch einen Stromrichter mit mindestens einem derartigen Halbleitermodul.

Darüber hinaus wird die Aufgabe erfindungsgemäß gelöst durch ein Verfahren zur Herstellung eines derartigen Halbleitermoduls, wobei das Halbleiterelement im Bereich der Profilierung mit der Metallisierungsoberfläche des Substrats stoffschlüssig verbunden wird.

Die in Bezug auf das Halbleitermodul nachstehend angeführten Vorteile und bevorzugten Ausgestaltungen lassen sich sinngemäß auf den Stromrichter und das Herstellungsverfahren übertragen.

Der Erfindung liegt die Überlegung zugrunde, die Zuverlässigkeit eines Halbleitermoduls zu verbessern, indem ein thermomechanischer Stress bei zumindest einer stoffschlüssigen Verbindung zwischen zumindest einem Halbleiterelement und einem Substrat reduziert wird. Ein derartiges Substrat umfasst eine dielektrische Materiallage sowie eine, insbesondere strukturierte, obere Metallisierung. Eine dielektrische Materiallage ist beispielsweise aus einem keramischen Werkstoff, insbesondere Aluminiumnitrid oder Aluminiumoxid, oder einen organischen Werkstoff, insbesondere einem Polyamid, hergestellt. Darüber hinaus weist die dielektrische Materiallage beispielsweise eine Dicke von 25 µm bis 400 µm, insbesondere 50 µm bis 380 µm, auf. Die obere Metallisierung ist beispielsweise aus Kupfer, Gold, Silber, Aluminium und/oder deren Legierungen hergestellt. Eine strukturierte Metallisierung weist elektrisch voneinander isolierte Bereiche, beispielsweise Leiterbahnen und/oder Kontaktierungspads, auf.

Das zumindest eine Halbleiterelement wird über eine Verbindungsschicht stoffschlüssig mit der oberen Metallisierung des Substrats verbunden, wobei die stoffschlüssige Verbindung beispielsweise durch Löten oder Sintern hergestellt wird. Die Verbindungsschicht enthält einen, insbesondere metallischen, Verbindungswerkstoff zur Herstellung einer elektrisch und thermisch leitfähigen Verbindung zwischen dem Halbleiterelement und dem Substrat.

Der insbesondere in der Verbindungsschicht während des Betriebes auftretende thermomechanische Stress wird reduziert, indem eine Metallisierungsoberfläche der oberen Metallisierung des Substrats profiliert ausgestaltet ist. Eine derartige Profilierung weist beispielsweise Vertiefungen im µm-Bereich auf, die dazu führen, dass die Verbindungsschicht eine örtlich variable Stärke aufweist. Durch die Profilierung kommt es zu einer Kontaktflächenvergrößerung zwischen der Verbindungsschicht und der oberen Metallisierung des Substrats, was zu einer stabileren Verbindung zwischen dem Halbleiterelement und dem Substrat führt. Ferner wird eine Verzahnung zwischen der Verbindungsschicht mit der oberen Metallisierung des Substrats erreicht. Durch eine derartige Verzahnung wird thermomechanisch induzierter Stress kompensiert, was eine Verlangsamung des Alterungsprozesses der Verbindungsschicht bewirkt und die Zuverlässigkeit des Moduls verbessert. Ferner wird durch die Profilierung eine Rissbildung, insbesondere in der Verbindungsschicht, reduziert oder gestoppt. Darüber hinaus wird durch die Profilierung eine mittlere Stärke der Verbindungsschicht reduziert, was eine verbesserte Wärmeabfuhr ermöglicht.

Eine weitere Ausführungsform sieht vor, dass die, insbesondere mittlere, Stärke der Verbindungsschicht durch die Profilierung der Metallisierungsoberfläche an einen Temperaturgradienten des Halbleiterelements angepasst ist. Insbesondere ist ein derartiger Temperaturgradient abhängig von einer lokal auftretenden Verlustleistung, beispielsweise auf dem Halbleiterelement, wobei der Temperaturgradient ohne eine Profilierung der Metallisierungsoberfläche auftritt. Eine mittlere Stärke der Verbindungsschicht wird über einen bestimmten Bereich der Verbindungsschicht, beispielsweise durch Mittelwertbildung der Stärke, ermittelt. Durch eine derartige temperaturprofilfolgend ausgeführte Stärke der Verbindungsschicht wird lokal eine verbesserte Entwärmung erzielt, was zu einer homogeneren Temperaturverteilung auf dem Halbleiterelement führt.

Eine weitere Ausführungsform sieht vor, dass die, insbesondere mittlere, Stärke der Verbindungsschicht bei zunehmender Temperatur des Temperaturgradienten abnimmt. Insbesondere da die Verbindungschicht eine niedrigere Wärmeleitfähigkeit aufweist als die obere Metallisierung, wird im Bereich einer dünneren Verbindungsschicht eine höhere Wärmeableitung erreicht, sodass, beispielsweise bei auftretenden Hotspots, eine gleichmäßige Wärmeableitung erreicht wird, was zu einer homogenen Temperaturverteilung auf dem Halbleiterelement führt. Ferner ist eine thermomechanische Wölbung des Halbleiters, beispielsweise bei einem Lötvorgang, kompensierbar.

Eine weitere Ausführungsform sieht vor, dass die Verbindungsschicht durch die Profilierung der Metallisierungsoberfläche, insbesondere mehrfach, unterbrochen ist. Durch Unterbrechungen wird eine zusammenhängende Fläche der Verbindungsschicht erheblich verringert, was dazu führt, dass eine eventuell auftretende Rissbildung gestoppt wird. Ferner ist das Halbleiterelement im Bereich der Unterbrechungen der Verbindungsschicht unmittelbar oder über die Bildung von harten intermetallischen Phasen mit der oberen Metallisierung verbunden, was eine verbesserte Wärmeabfuhr ermöglicht.

Eine weitere Ausführungsform sieht vor, dass die Verbindungsschicht durch die Profilierung der Metallisierungsoberfläche einen Bereich einer ersten Stärke und einen Bereich einer zweiten Stärke aufweist, wobei die erste Stärke größer als die zweite Stärke ist. Die unterschiedlichen Stärken der Profilierung führen zu einer Verzahnung der Verbindungsschicht mit der oberen Metallisierung des Substrats. Durch eine derartige Verzahnung wird thermomechanisch induzierter Stress kompensiert, was eine Verlangsamung des Alterungsprozesses der Verbindungsschicht bewirkt und die Zuverlässigkeit des Moduls verbessert.

Eine weitere Ausführungsform sieht vor, dass die zweite Stärke maximal 20 µm beträgt. Beim Herstellen der stoffschlüssigen Verbindung, insbesondere beim Löten, kommt es bei einer derartigen zweiten Stärke zur Bildung einer intermetallischen Phase zwischen Halbleitermetallisierung und Substratmetallisierung. Die intermetallische Phase führt zu einer spröden und harten Verbindung zwischen der oberen Metallisierung des Substrats und dem Halbleiterelement. Ein Schmelzpunkt der intermetallischen Phase ist höher als die verwendete Prozesstemperatur.

Eine weitere Ausführungsform sieht vor, dass die Profilierung der Metallisierungsoberfläche periodisch ausgeführt ist. Eine periodisch ausgeführte Profilierung weist ein bezüglich seiner Abmessungen und/oder Form wiederkehrendes Muster auf. Eine derartige Profilierung sorgt für eine über die Fläche gleichmäßig stabile Verbindung des Halbleiterelements mit der oberen Metallisierung des Substrats und ist einfach und kostengünstig herzustellen.

Eine weitere Ausführungsform sieht vor, dass die Profilierung der Metallisierungsoberfläche zylinderförmige Kavitäten umfasst. Derartige sacklochförmige Strukturen sind beispielsweise als Bohrlöcher ausgeführt, welche mittels spanender Bearbeitung hergestellt sind. Zylinderförmige Kavitäten sind einfach und kostengünstig herstellbar.

Eine weitere Ausführungsform sieht vor, dass die Profilierung der Metallisierungsoberfläche linienförmige Kavitäten umfasst. Beispielsweise sind die Kavitäten als gerade linienförmige Kavitäten ausgeführt. Ein Querschnitt derartiger linienförmiger Kavitäten ist beispielsweise rechteckig, quadratisch oder trapezförmig. Die Stärke der Verbindungsschicht ist, beispielsweise mittels spanender Bearbeitung einfach und kostengünstig einstellbar. Mit linienförmigen Kavitäten ergibt sich eine hohe Gestaltungsfreiheit.

Eine weitere Ausführungsform sieht vor, dass die linienförmigen Kavitäten konzentrische Ellipsen ausbilden. Kavitäten in Form von konzentrischen Ellipsen wirken einem Risswachstum in der Verbindungsschicht entgegen, da sich derartige Risse von innen nach außen, insbesondere entlang eines Temperaturgradienten, ausbreiten.

Eine weitere Ausführungsform sieht vor, dass die Profilierung pyramidenförmige Erhebungen und/oder pyramidenstumpfförmige Erhebungen umfasst. Durch eine pyramidenförmige und/oder pyramidenstumpfförmige Profilierung wird eine optimale Verzahnung zwischen der Verbindungsschicht mit der oberen Metallisierung des Substrats erreicht. Insbesondere durch pyramidenförmige Erhebungen wird ein sehr geringer Abstand zwischen dem Halbleiterelement und der oberen Metallisierung des Substrats ermöglicht, wodurch ein Wachstum der intermetallischen Phase gezielt erhöht wird.

Eine weitere Ausführungsform sieht vor, dass die Erhebungen unterhalb der Metallisierungsoberfläche und/oder bündig mit der Metallisierungsoberfläche abschließend ausgeführt sind. Ein Verlaufen des Verbindungswerkstoffs zur Herstellung der stoffschlüssigen Verbindung durch die Profilierung wird gezielt gesteuert, sodass das Halbleiterelement ohne weitere Hilfsmittel oder Werkzeuge wie "Solder-Jigs" oder Lötstopplack mit dem Substrat verbindbar ist. Insbesondere unterhalb der Metallisierungsoberfläche abschließende Erhebungen führen dazu, dass das Halbleiterelement lokal, insbesondere durch Formschluss, positioniert wird.

Eine weitere Ausführungsform sieht vor, dass die Profilierung mit Hilfe eines Lasers, nasschemisch und/oder mittels spanender Bearbeitung hergestellt wird. Während eine mittels Laser hergestellte Profilierung sehr präzise herstellbar ist, ist eine Profilierung mittels spanender Bearbeitung, beispielsweise durch Bohren und/oder Fräsen einfach und kostengünstig herzustellen. Eine nasschemische Herstellung der Profilierung, beispielsweise mittels Ätzen, ist ebenfalls präzise und kostengünstig herzustellen.

Im Folgenden wird die Erfindung anhand der in den Figuren dargestellten Ausführungsbeispiele näher beschrieben und erläutert.

Es zeigen:
- FIG 1: eine schematische Darstellung einer ersten Ausgestaltung eines Halbleitermoduls im Querschnitt,
- FIG 2: eine vergrößerte schematische Darstellung der ersten Ausgestaltung des Halbleitermoduls im Querschnitt,
- FIG 3: eine vergrößerte schematische Darstellung der oberen Metallisierung des Substrats der ersten Ausgestaltung des Halbleitermoduls in einer Draufsicht,
- FIG 4: eine vergrößerte schematische Darstellung einer zweiten Ausgestaltung des Halbleitermoduls im Querschnitt,
- FIG 5: eine vergrößerte schematische Darstellung einer dritten Ausgestaltung des Halbleitermoduls im Querschnitt,
- FIG 6: eine vergrößerte schematische Darstellung einer oberen Metallisierung eines Substrats einer vierten Ausgestaltung eines Halbleitermoduls in einer Draufsicht,
- FIG 7: eine vergrößerte schematische Darstellung der oberen Metallisierung des Substrats mit zylinderförmigen Kavitäten im Querschnitt,
- FIG 8: eine vergrößerte schematische Darstellung einer oberen Metallisierung eines Substrats einer fünften Ausgestaltung eines Halbleitermoduls in einer Draufsicht,
- FIG 9: eine vergrößerte schematische Darstellung einer oberen Metallisierung eines Substrats einer sechsten Ausgestaltung eines Halbleitermoduls in einer Draufsicht,
- FIG 10: eine vergrößerte schematische Darstellung einer oberen Metallisierung eines Substrats einer siebten Ausgestaltung eines Halbleitermoduls in einer Draufsicht,
- FIG 11: eine vergrößerte schematische Darstellung der oberen Metallisierung des Substrats mit linienförmigen Kavitäten im Querschnitt,
- FIG 12: eine vergrößerte schematische Darstellung einer achten Ausgestaltung des Halbleitermoduls im Querschnitt und
- FIG 13: zeigt eine vergrößerte schematische Darstellung einer neunten Ausgestaltung des Halbleitermoduls im Querschnitt.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

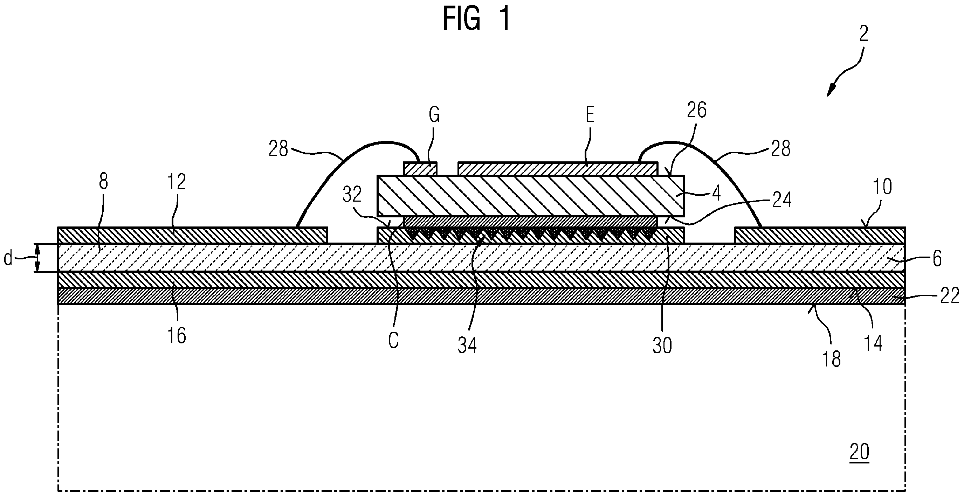

FIG 1 zeigt eine schematische Darstellung einer ersten Ausgestaltung eines Halbleitermoduls 2 im Querschnitt. Das Halbleitermodul 2 weist ein Halbleiterelement 4 und ein Substrat 6 auf, wobei das Halbleiterelement 4 exemplarisch als Insulated-Gate-Bipolar-Transistor (IGBT) ausgeführt ist. Das Halbleiterbauelement 4 kann auch als Metalloxide-Semiconductor-Field-Effect-Transistor (MOSFET), als Feldeffekttransistor, als Diode, als Logikbaustein, insbesondere als Field Programmable Gate Array (FPGA) oder als ein anderer Halbleiter ausgeführt sein. Insbesondre weist das Halbleiterbauelement 4 eine Fläche von mindestens 10 mm² auf. Das Substrat 6 umfasst eine dielektrische Materiallage 8, die einen keramischen Werkstoff, beispielsweise Aluminiumnitrid oder Aluminiumoxid, oder einen organischen Werkstoff, beispielsweise einem Polyamid enthält. Ferner weist die dielektrische Materiallage 8 eine Dicke d von 25 µm bis 400 µm, insbesondere 50 µm bis 250 µm, auf. Darüber hinaus weist das Substrat 6 auf einer dem Halbleiterelement 4 zugewandten Seite 10 eine, insbesondere strukturierte, obere Metallisierung 12 und auf einer dem Halbleiterelement 4 abgewandten Seite 14 eine untere Metallisierung 16 auf, wobei das Substrat 6 stoffschlüssig mit einer Oberfläche 18 eines Kühlkörpers 20 verbunden ist. Die obere Metallisierung 12 und die untere Metallisierung 16 sind beispielsweise aus Kupfer hergestellt. Eine Verbindungslage 22 der stoffschlüssigen Verbindung zum Kühlkörper 20 ist durch Löten oder Sintern hergestellt.

Das beispielhaft als IGBT ausgeführte Halbleiterelement 4 weist auf einer dem Substrat 6 zugewandte Seite 24 einen Kollektor-Kontakt C und auf einer dem Substrat 6 abgewandten Seite 26 einen Emitter-Kontakt E und einen Gate-Kontakt G auf. Der Emitter-Kontakte E und der Gate-Kontakt G des als IGBT ausgeführten Halbleiterelements 4 sind, voneinander elektrisch isoliert, über Bondverbindungen 28 mit der oberen Metallisierung 12 des Substrats 6 verbunden. Der Kollektor-Kontakt C des Halbleiterelements 4 ist über eine Verbindungsschicht 30 stoffschlüssig mit der oberen Metallisierung 12 des Substrats 6 verbunden, wobei die stoffschlüssige Verbindung durch Löten oder Sintern hergestellt ist. Die Verbindungsschicht enthält einen Metallischen Werkstoff zur Herstellung einer elektrisch und thermisch leitfähigen Verbindung zwischen dem Halbleiterelement 4 und dem Substrat 6. Dementsprechend steht das Halbleiterelement 4 mit dem Kühlkörper 20 in einer elektrisch isolierenden und thermisch leitfähigen Verbindung, sodass im Halbleiterelement 4 entstehende Verlustwärme über den Kühlkörper 20 abführbar ist.

Eine Metallisierungsoberfläche 32 der oberen Metallisierung 12 des Substrats 6 ist im Bereich der Verbindung mit dem Kollektor-Kontakt C des Halbleiterelements 4 profiliert ausgestaltet, wobei die Verbindungsschicht 30 durch die Profilierung 34 der Metallisierungsoberfläche 32 eine variable Stärke aufweist. Die Profilierung 34 wird mit Hilfe eines Lasers, nasschemisch und/oder mittels spanender Bearbeitung hergestellt.

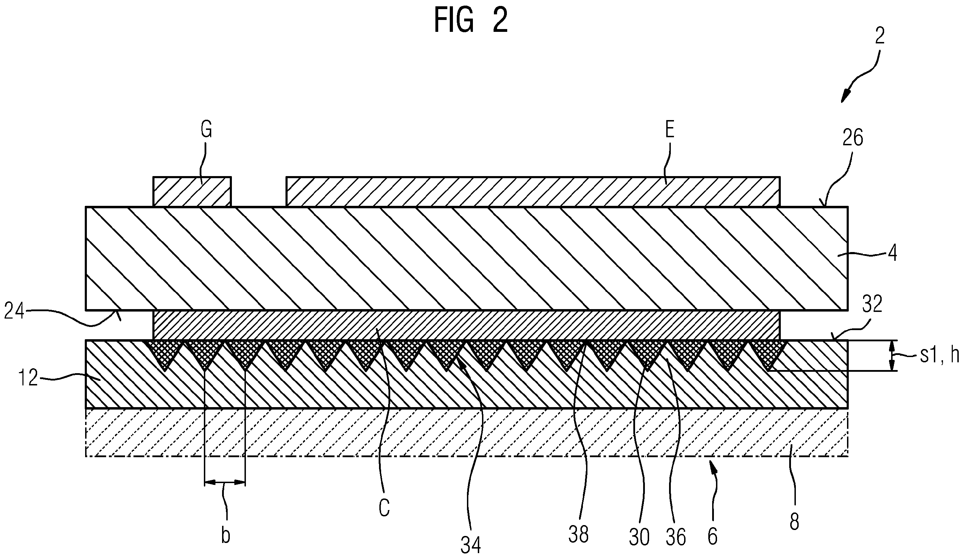

FIG 2 zeigt eine vergrößerte schematische Darstellung der ersten Ausgestaltung des Halbleitermoduls 2 im Querschnitt, wobei die Profilierung 34 periodisch angeordnete pyramidenförmige Erhebungen 36 umfasst. Die pyramidenförmigen Erhebungen 36 sind bündig mit der oberen Metallisierungsoberfläche 12 abschließend ausgeführt, wobei die Verbindungsschicht 30 durch die pyramidenförmigen Erhebungen 36 der Profilierung 34 mehrfach unterbrochen ist, um eine Rissbildung in der Verbindungsschicht 30 zu verhindern. Die pyramidenförmigen Erhebungen 36 sind jeweils symmetrisch. Ferner weisen sie jeweils eine Breite b im Bereich von 1 µm bis 200 µm, insbesondere 10 µm bis 200 µm, und eine Höhe h von 20 µm bis 200 µm auf. Der Kollektor-Kontakt C des Halbleiterelements 4 ist mit den Spitzen 38 der pyramidenförmigen Erhebungen 36 direkt kontaktiert. Eine erste Stärke s1 der Verbindungsschicht 30, welche einer maximalen Stärke entspricht, beträgt demnach maximal 200 µm. Eine minimale Stärke ist durch die direkte Kontaktierung des Kollektor-Kontakts C mit den Spitzen 38 gleich Null. Durch Variation der Abmessungen b, h der pyramidenförmigen Erhebungen 36 ist eine örtlich unterschiedliche Dichte der Profilierung 34 erhältlich wodurch ein Temperaturgradient auf dem Halbleiterelement 4 gezielt beeinflussbar ist. Auf diese Weise ist eine verbesserte Entwärmung von Hotspots erreichbar. Ferner ist eine thermomechanische Wölbung des Halbleiterelements 4 beim Herstellen der stoffschlüssigen Verbindung, z.B. durch Löten, kompensierbar. Die weitere Ausgestaltung des Halbleitermoduls 2 in FIG 2 entspricht der Ausgestaltung in FIG 1.

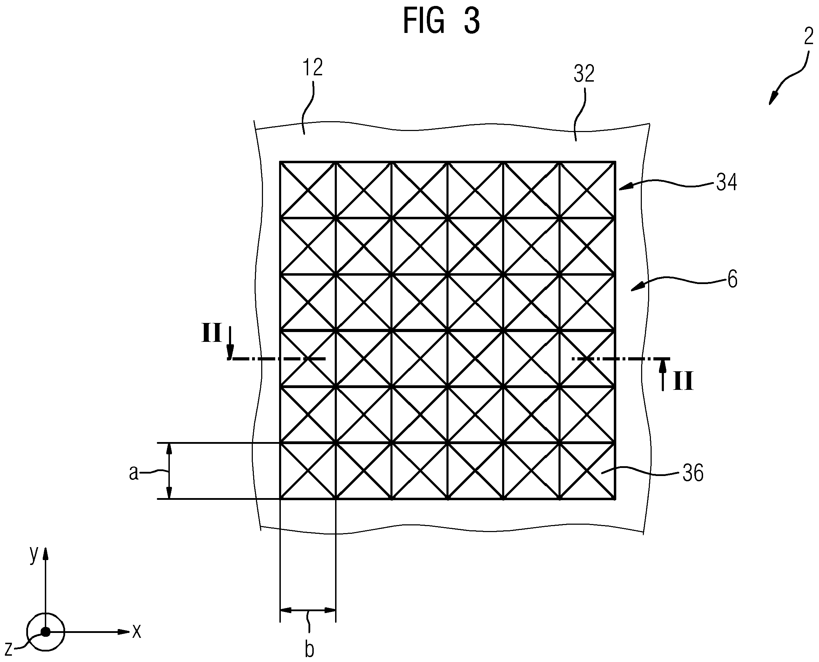

FIG 3 zeigt eine vergrößerte schematische Darstellung der oberen Metallisierung 12 des Substrats 6 der ersten Ausgestaltung des Halbleitermoduls 2 in einer Draufsicht. Die Metallisierungsoberfläche 32 definiert eine x-Achse, eine y-Achse und eine z-Achse, wobei die Metallisierungsoberfläche 32 in einer xy-Ebene liegt. Die pyramidenförmigen Erhebungen 36 der Profilierung 34 weisen eine quadratische Grundfläche mit identischen Seitenlängen a, b auf. Ferner sind die pyramidenförmigen Erhebungen 36 äquidistant in einer x-Richtung und einer y-Richtung angeordnet. Die weitere Ausgestaltung des Halbleitermoduls 2 in FIG 3 entspricht der Ausgestaltung in FIG 2.

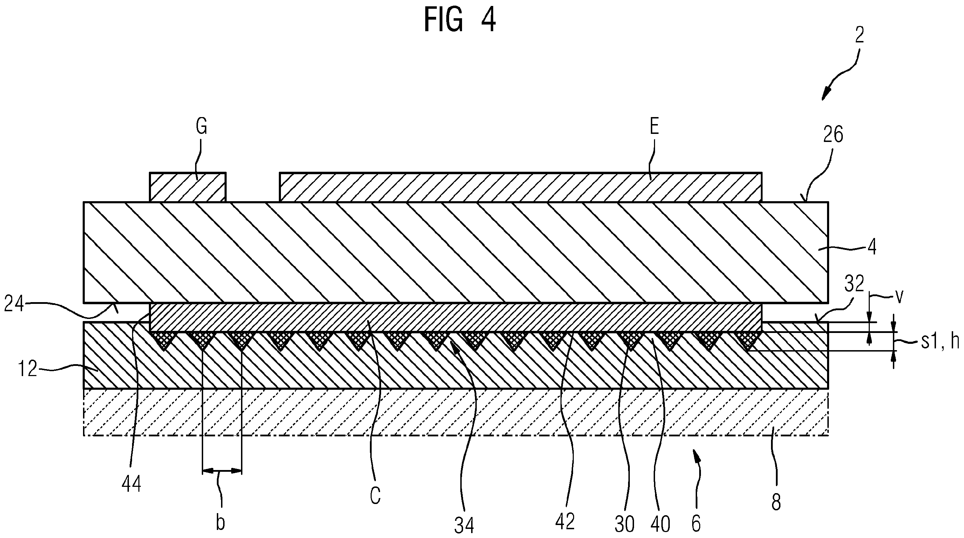

FIG 4 zeigt eine vergrößerte schematische Darstellung einer zweiten Ausgestaltung des Halbleitermoduls 2 im Querschnitt, wobei die Profilierung 34 periodisch angeordnete pyramidenstumpfförmige Erhebungen 40 umfasst. Die pyramidenstumpfförmigen Erhebungen 40 sind unterhalb der Metallisierungsoberfläche 32 abgeschlossen, wobei der Kollektor-Kontakt C des Halbleiterelements 4 mit den Deckflächen 42 der pyramidenstumpfförmigen Erhebungen 40 direkt kontaktiert ist. Insbesondere schließen die Deckflächen 42 die pyramidenstumpfförmigen Erhebungen 40 um eine Vertiefung v, welche beispielsweise im pm-Bereich liegt, unterhalb der Metallisierungsoberfläche 32 ab. Durch die unterhalb der Metallisierungsoberfläche 32 angeordnete Profilierung 34 wird eine Kavität 44 ausgebildet, in welcher der Kollektor-Kontakt C des Halbleiterelements 4 über die Verbindungsschicht 30 mit der oberen Metallisierung 12 des Substrats 6 stoffschlüssig verbunden ist, wobei die Verbindungsschicht 30 durch die pyramidenstumpfförmigen Erhebungen 40 der Profilierung 34 mehrfach unterbrochen ist, um eine Rissbildung in der Verbindungsschicht 30 zu verhindern. Durch die Anordnung des Kollektor-Kontakts C in der Kavität 44 wird eine präzise Positionierung des Halbleiterelements 4 vereinfacht.

Die pyramidenstumpfförmigen Erhebungen 40 sind jeweils symmetrisch. Ferner weisen sie jeweils eine Breite b im Bereich von 2 µm bis 200 µm, insbesondere 20 µm bis 200 µm, und eine Höhe h von 20 µm bis 200 µm auf. Da der Kollektor-Kontakt C des Halbleiterelements 4 mit den Deckflächen 42 der pyramidenstumpfförmigen Erhebungen 40 direkt kontaktiert ist, ist eine minimale Stärke der Verbindungsschicht 30 gleich Null. Eine erste Stärke s1 der Verbindungsschicht 30, welche einer maximalen Stärke entspricht, beträgt maximal 200 µm. Die weitere Ausgestaltung des Halbleitermoduls 2 in FIG 4 entspricht der Ausgestaltung in FIG 2.

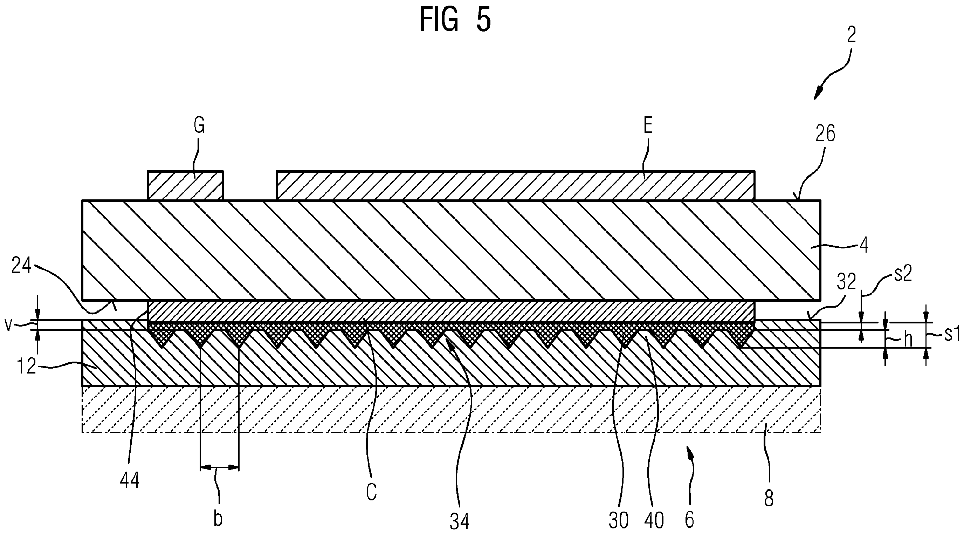

FIG 5 zeigt eine vergrößerte schematische Darstellung einer dritten Ausgestaltung des Halbleitermoduls 2 im Querschnitt, wobei die Verbindungsschicht 30 durch die pyramidenstumpfförmigen Erhebungen 40 der Profilierung 34 einen Bereich einer ersten Stärke s1 und einen Bereich einer zweiten Stärke s2 aufweist und wobei die erste Stärke s1 größer als die zweite Stärke s2 ist. Die erste Stärke s1 entspricht einer maximalen Stärke der der Verbindungsschicht 30, während die zweite Stärke s2, welche maximal 20 µm beträgt, einer minimalen Stärke der Verbindungsschicht 30 entspricht. Da die zweite Stärke s2 maximal 20 µm beträgt, kommt es beispielsweise beim Löten zu einer Eindiffundierung, was zu einer Senkung des Schmelzpunkts führt. Die intermetallische Phase führt zu einer spröden und harten Verbindung zwischen der oberen Metallisierung 12 des Substrats 6 und dem Kollektor-Kontakt C des Halbleiterelements 4. Die weitere Ausgestaltung des Halbleitermoduls 2 in FIG 5 entspricht der Ausgestaltung in FIG 4.

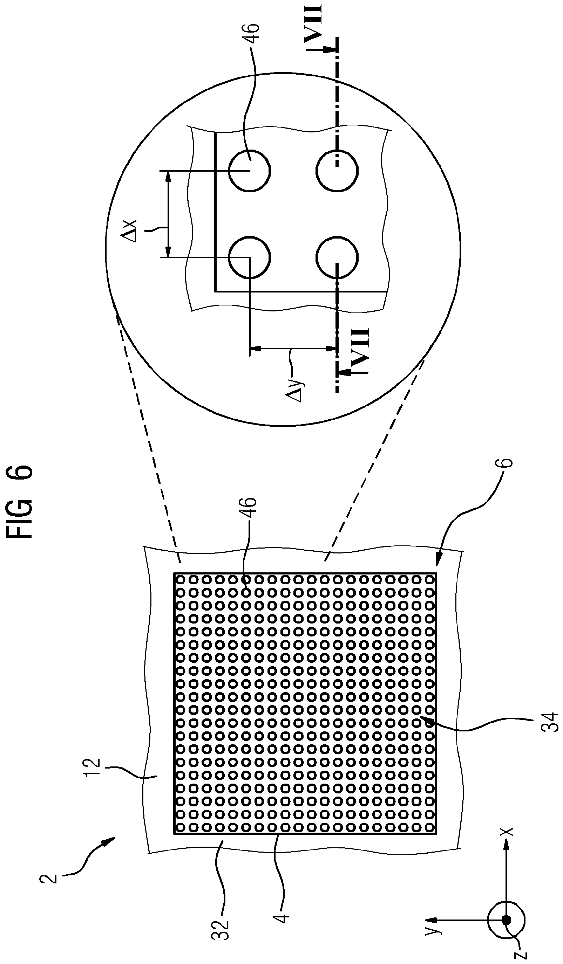

FIG 6 zeigt eine vergrößerte schematische Darstellung einer oberen Metallisierung 12 eines Substrats 6 einer vierten Ausgestaltung eines Halbleitermoduls 2 in einer Draufsicht. Die Profilierung 34 der Metallisierungsoberfläche 32 ist aus zylinderförmigen Kavitäten 46 aufgebaut, welche periodisch unterhalb des Halbleiterelements 4 angeordnet sind. Die zylinderförmigen Kavitäten 46 sind dafür konfiguriert, insbesondere im Wesentlichen vollständig, mit einem Verbindungsmaterial, beispielsweise Lötzinn oder Sinterpaste, der Verbindungsschicht 30 gefüllt zu werden. Insbesondere sind die zylinderförmigen Kavitäten 46 der Profilierung 34 äquidistant angeordnet, was bedeutet, dass benachbarte zylinderförmige Kavitäten 46 jeweils einen Abstand Δx in x-Richtung und/oder einen Abstand Δy in y-Richtung aufweisen, wobei der Abstand Δx in x-Richtung dem Abstand Δy in y-Richtung entspricht. Die weitere Ausgestaltung des Halbleitermoduls 2 in FIG 6 entspricht der Ausgestaltung in FIG 1.

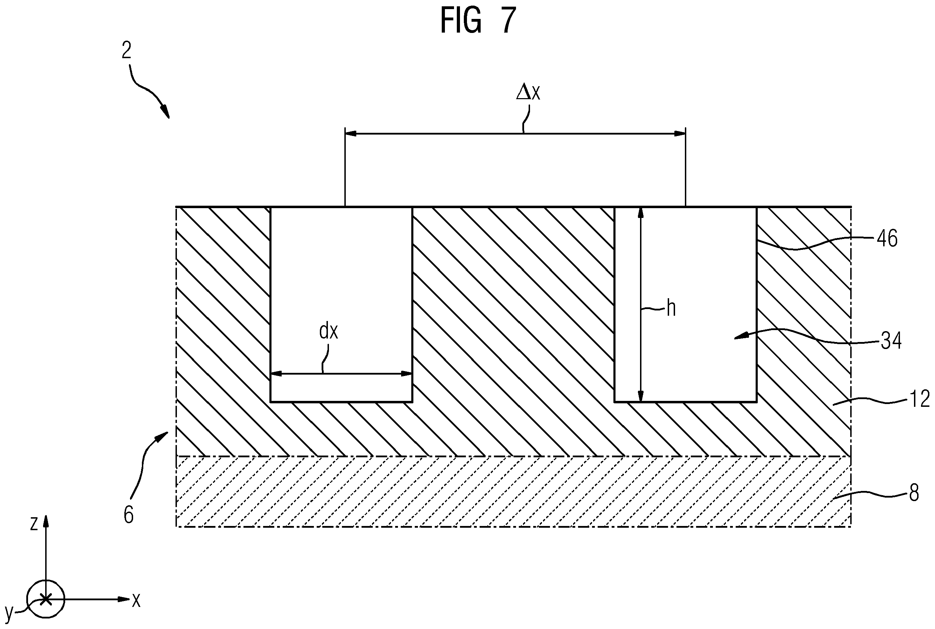

FIG 7 zeigt eine vergrößerte schematische Darstellung der oberen Metallisierung 12 des Substrats 6 mit zylinderförmigen Kavitäten 46 im Querschnitt. Die zylinderförmigen Kavitäten 46, welche eine runde oder ovale Grundfläche aufweisen, sind exemplarisch als sacklochförmige Vertiefungen mit einem Durchmesser dx im Bereich von 1 µm bis 200 µm, insbesondere 10 µm bis 100 µm, und einer Höhe h von 20 µm bis 200 µm ausgeführt. Ein Abstand Δx in x-Richtung liegt beim ein- bis fünffachen Durchmesser dx. Die zylinderförmigen Kavitäten 46 sind beispielsweise als Bohrlöcher ausgeführt, welche mittels spanender Bearbeitung hergestellt sind. Die weitere Ausgestaltung des Halbleitermoduls 2 in FIG 7 entspricht der Ausgestaltung in FIG 6.

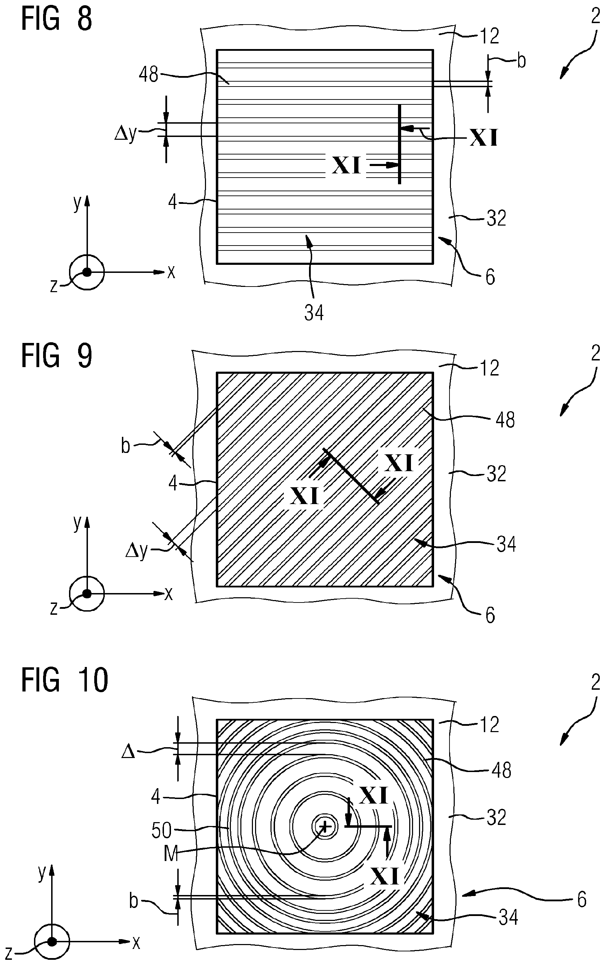

FIG 8 zeigt eine vergrößerte schematische Darstellung einer oberen Metallisierung 12 eines Substrats 6 einer fünften Ausgestaltung eines Halbleitermoduls 2 in einer Draufsicht. Die Profilierung 34 der Metallisierungsoberfläche 32 ist aus geraden linienförmigen Kavitäten 48 aufgebaut, welche parallel zueinander in x-Richtung verlaufend angeordnet sind. Ein Querschnitt der linienförmigen Kavitäten 48 ist rechteckig, quadratisch oder trapezförmig aufgebaut. Eine Bereite b und ein Abstand Δy in y-Richtung der parallel zueinander in x-Richtung verlaufenden linienförmigen Kavitäten 48 variieren beispielsweise zur gezielten Beeinflussung eines Temperaturgradienten auf dem Halbleiterelement 4. Die weitere Ausgestaltung des Halbleitermoduls 2 in FIG 8 entspricht der Ausgestaltung in FIG 1.

FIG 9 zeigt eine vergrößerte schematische Darstellung einer oberen Metallisierung 12 eines Substrats 6 einer sechsten Ausgestaltung eines Halbleitermoduls 2 in einer Draufsicht, wobei die linienförmigen Kavitäten 48 parallel und diagonal zu den Kanten des rechteckigen Halbleiterelements 4 verlaufend angeordnet sind. Eine Bereite b und ein Abstand Δ der parallel zueinander verlaufenden linienförmigen Kavitäten 48 sind konstant. Die weitere Ausgestaltung des Halbleitermoduls 2 in FIG 9 entspricht der Ausgestaltung in FIG 8.

FIG 10 zeigt eine vergrößerte schematische Darstellung einer oberen Metallisierung 12 eines Substrats 6 einer siebten Ausgestaltung eines Halbleitermoduls 2 in einer Draufsicht, wobei die linienförmigen Kavitäten 48 als konzentrische Ellipsen 50 um einen Mittelpunkt M ausgebildet sind. Insbesondere sind die linienförmigen Kavitäten 48 als konzentrische Kreise um den Mittelpunkt M ausgebildet. Eine Bereite b der konzentrischen Ellipsen 50 ist beispielhaft konstant, während ein Abstand Δ variiert. Insbesondere nimmt der Abstand Δ der konzentrischen Ellipsen 50 zum Mittelpunkt M hin zu. Die weitere Ausgestaltung des Halbleitermoduls 2 in FIG 10 entspricht der Ausgestaltung in FIG 8.

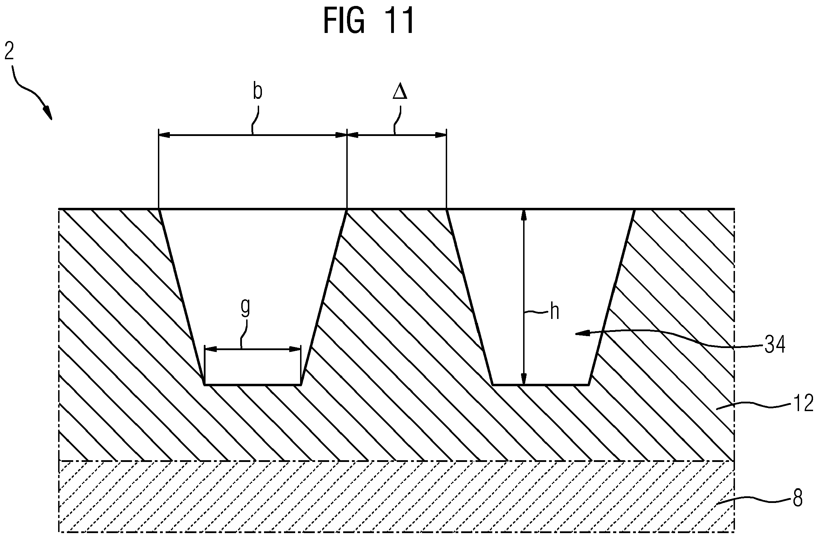

FIG 11 zeigt eine vergrößerte schematische Darstellung der oberen Metallisierung 12 des Substrats 6 mit linienförmigen Kavitäten 48 im Querschnitt. Die linienförmigen Kavitäten 48 weisen beispielhaft einen trapezförmigen Querschnitt auf. Alternativ weisen die linienförmigen Kavitäten 48 beispielsweise einen quadratischen, rechteckigen oder dreieckigen Querschnitt auf. Die Breite der Grundfläche g des trapezförmigen Querschnitts der linienförmigen Kavität 48 ist kleiner als die Breite b. Beispielsweise liegen die Breite b in einem Bereich von 1 µm bis 200 µm, insbesondere 10 µm bis 100 µm, und die Höhe h in einem Bereich von 20 µm bis 200 µm. Der Abstand Δ liegt beispielsweise in einem Bereich von 1 µm bis 200 µm, insbesondere 10 µm bis 100 µm. Die weitere Ausgestaltung des Halbleitermoduls 2 in FIG 11 entspricht der Ausgestaltung in FIG 7.

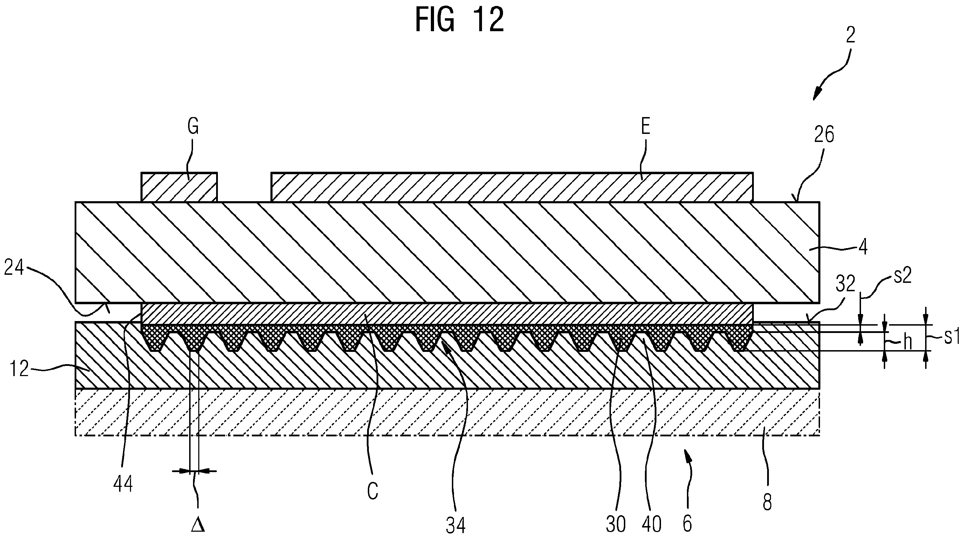

FIG 12 zeigt eine vergrößerte schematische Darstellung einer achten Ausgestaltung des Halbleitermoduls 2 im Querschnitt, wobei die Verbindungsschicht 30 durch beabstandete pyramidenstumpfförmigen Erhebungen 40 der Profilierung 34 einen Bereich einer ersten Stärke s1 und einen Bereich einer zweiten Stärke s2 aufweist und wobei die erste Stärke s1 größer als die zweite Stärke s2 ist. Ein Abstand Δ zwischen den pyramidenstumpfförmigen Erhebungen 40 liegt beispielsweise in einem Bereich von 1 µm bis 200 µm, insbesondere 10 µm bis 100 µm. Die weitere Ausgestaltung des Halbleitermoduls 2 in FIG 12 entspricht der Ausgestaltung in FIG 5.

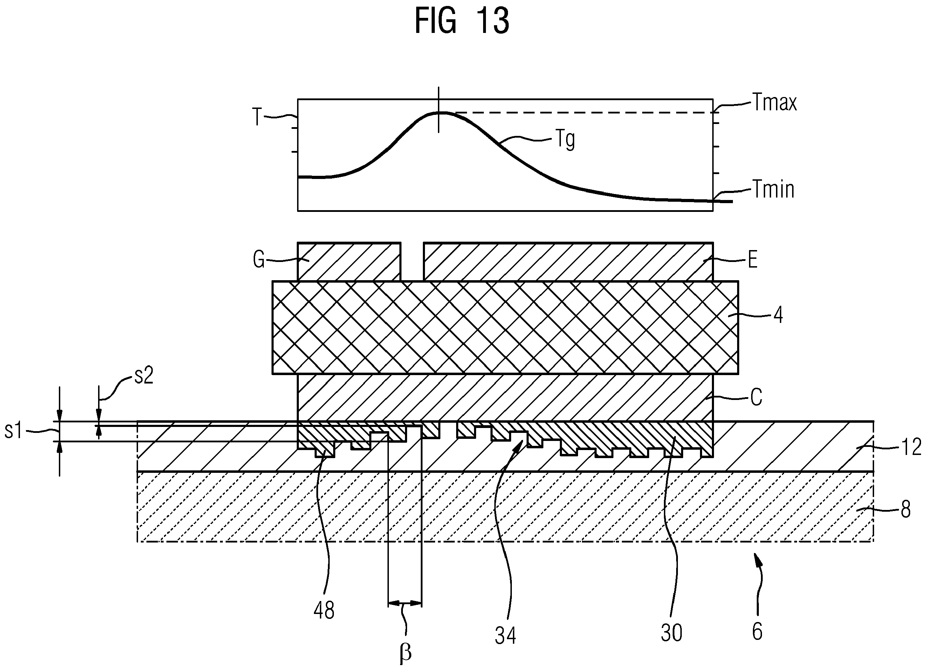

FIG 13 zeigt eine vergrößerte schematische Darstellung einer neunten Ausgestaltung des Halbleitermoduls 2 im Querschnitt. Die Profilierung 34 der Metallisierungsoberfläche 32 weist beispielhaft linienförmige Kavitäten 48 auf. Eine Stärke s1, s2 der Verbindungsschicht 30 ist temperaturprofilfolgend ausgeführt. Unter einer temperaturprofilfolgenden Ausführung ist zu verstehen, dass die Verbindungsschicht 30 durch die Profilierung 34 der Metallisierungsoberfläche 32 an einen Temperaturgradienten Tg des Halbleiterelements 4, welcher insbesondere ohne eine Verbindungsschicht 30 mit variabler Stärke auftritt und abhängig von lokal auftretenden Verlustleistungen ist, angepasst ist. Insbesondere ist eine mittlere Stärke der Verbindungsschicht 30 an den Temperaturgradienten Tg des Halbleiterelements 4 angepasst, wobei die mittlere Stärke der Verbindungsschicht 30 über einen bestimmten Bereich β, beispielsweise durch Mittelwertbildung der Stärken s1, s2, ermittelt wird. Die, insbesondere mittlere, Stärke s1, s2 der Verbindungsschicht 30 nimmt bei zunehmender Temperatur T des Temperaturgradienten Tg ab. Demnach ist die, insbesondere mittlere, Stärke s1, s2 der Verbindungsschicht 30 bei der maximalen Temperatur Tmax des Temperaturgradienten Tg minimal, während die, insbesondere mittlere, Stärke s1, s2 der Verbindungsschicht 30 bei der minimalen Temperatur Tmin des Temperaturgradienten Tg minimal ist. Die weitere Ausgestaltung des Halbleitermoduls 2 in FIG 13 entspricht der Ausgestaltung in FIG 12.

Zusammenfassend betrifft die Erfindung ein Halbleitermodul 2 mit zumindest einem Halbleiterelement 4 und einem Substrat 6. Um, im Vergleich zum Stand der Technik, eine verbesserte Wärmeabfuhr und höhere Zuverlässigkeit zu erreichen, wird vorgeschlagen, dass das Substrat 6 eine obere Metallisierung 12 aufweist, wobei das zumindest eine Halbleiterelement 4 über eine Verbindungsschicht 30 stoffschlüssig mit der oberen Metallisierung 12 des Substrats 6 verbunden ist, wobei eine Metallisierungsoberfläche 32 der oberen Metallisierung 12 profiliert ausgestaltet ist, wobei die Verbindungsschicht 30 durch die Profilierung 34 der Metallisierungsoberfläche 32 eine variable Stärke s1, s2 aufweist.

## Patentansprüche

1. Halbleitermodul (2) mit zumindest einem Halbleiterelement (4) und einem Substrat (6),
wobei das Substrat (6) eine obere Metallisierung (12) aufweist,
wobei das zumindest eine Halbleiterelement (4) über eine Verbindungsschicht (30) stoffschlüssig mit der oberen Metallisierung (12) des Substrats (6) verbunden ist,
wobei eine Metallisierungsoberfläche (32) der oberen Metallisierung (12) profiliert ausgestaltet ist,
wobei die Verbindungsschicht (30) durch die Profilierung (34) der Metallisierungsoberfläche (32) eine variable Stärke (s1, s2) aufweist.

2. Halbleitermodul (2) nach Anspruch 1,
wobei die, insbesondere mittlere, Stärke (s1, s2) der Verbindungsschicht (30) durch die Profilierung (34) der Metallisierungsoberfläche (32) an einen Temperaturgradienten (Tg) des Halbleiterelements (4) angepasst ist.

3. Halbleitermodul (2) nach Anspruch 2,
wobei die, insbesondere mittlere, Stärke (s1, s2) der Verbindungsschicht (30) bei zunehmender Temperatur (T) des Temperaturgradienten (Tg) abnimmt.

4. Halbleitermodul (2) nach einem der vorherigen Ansprüche, wobei die Verbindungsschicht (30) durch die Profilierung (34) der Metallisierungsoberfläche (32), insbesondere mehrfach, unterbrochen ist.

5. Halbleitermodul (2) nach einem der vorherigen Ansprüche, wobei die Verbindungsschicht (30) durch die Profilierung (34) der Metallisierungsoberfläche (32) einen Bereich einer ersten Stärke (s1) und einen Bereich einer zweiten Stärke (s2) aufweist,
wobei die erste Stärke (s1) größer als die zweite Stärke (s2) ist.

6. Halbleitermodul (2) nach Anspruch 5,
wobei die zweite Stärke (s2) maximal 20 µm beträgt.

7. Halbleitermodul (2) nach einem der vorherigen Ansprüche, wobei die Profilierung (34) der Metallisierungsoberfläche (32) periodisch ausgeführt ist.

8. Halbleitermodul (2) nach einem der vorherigen Ansprüche, wobei die Profilierung (34) der Metallisierungsoberfläche (32) zylinderförmige Kavitäten (46) umfasst.

9. Halbleitermodul (2) nach einem der vorherigen Ansprüche, wobei die Profilierung (34) der Metallisierungsoberfläche (32) linienförmige Kavitäten (48) umfasst.

10. Halbleitermodul (2) nach Anspruch 9,
wobei die linienförmigen Kavitäten (48) konzentrische Ellipsen (50) ausbilden.

11. Halbleitermodul (2) nach einem der vorherigen Ansprüche, wobei die Profilierung (34) pyramidenförmige Erhebungen (36) und/oder pyramidenstumpfförmige Erhebungen (40) umfasst.

12. Halbleitermodul (2) nach Anspruch 11,
wobei die Erhebungen (36, 40) unterhalb der Metallisierungsoberfläche (32) und/oder bündig mit der Metallisierungsoberfläche (32) abschließend ausgeführt sind.

13. Stromrichter mit mindestens einem Halbleitermodul (2) nach einem der Ansprüche 1 bis 12.

14. Verfahren zur Herstellung eines Halbleitermoduls (2) nach einem der Ansprüche 1 bis 12,
wobei das Halbleiterelement (4) im Bereich der Profilierung (34) mit der Metallisierungsoberfläche (32) des Substrats (6) stoffschlüssig verbunden wird.

15. Verfahren zur Herstellung eines Halbleitermoduls (2) nach Anspruch 14,
wobei die Profilierung (34) mit Hilfe eines Lasers, nasschemisch und/oder mittels spanender Bearbeitung hergestellt wird.
